# EUROPEAN PATENT APPLICATION

(11) **EP 0 691 612 A1**
(43) Date of publication of application: **10.01.1996**
(21) Application number: 94480057.2
(22) Date of filing: 07.07.1994
(51) Int. Cl.: G06F 11/24

(54) **A test circuit of embedded arrays in mixed logic and memory chips**

(71) Applicant: INTERNATIONAL BUSINESS MACHINES CORPORATION, Armonk, NY 10504 (US)
(72) Inventor: Gabillard, Bertrand, F-75012 Paris (FR); Rivier, Michel, F-77630 Barbizon (FR)
(74) Representative: Klein, Daniel Jacques Henri

(57) **Abstract**

A test circuit (44) for embedded arrays in mixed chips, is provided wherein a control gate (44.1c to 44.Nc) is connected to a standard control signal (LT). According to the (LT) value, the test circuit (44) connects or isolates the memory unit (12.1) and the logic part (12.2,14) of the mixed chip. The test circuit (44) operates as a switch placed between the power supply rail of the logic part (46) and the power supply rail (48.1 to 48.N) of the memory unit (12.1). All the input gates (44.1a to 44.Na) are cross-connected to the power supply rail of the logic part (46), and each output gate (44.1b to 44.Nb) is connected to the corresponding power supply rail (48.1 to 48.N) of the memory unit (12.1). During the TEST mode of the chip, the value of the control signal (LT) turns off the test circuit (44), and the memory unit (12.1) is not supplied. The memory cells keep unselected, and the logic circuits network (14) is tested. The faulty chips are rejected. Then the value of the control signal (LT) is inverted, and the control gate (44.1c to 44.Nc) connects all the power supply rails (48.1 to 48.N) of the memory unit to the power supply rail of the logic part (46). Then the test sequence of the embedded array is performed. Faulty memory cells are replaced in case of repaired elements, otherwise faulty chips are rejected. Thus the manufacturing yield of the mixed chips is improved, and moreover SPQL of the shipped products is significantly decreased.

## Description

### Field of invention

The present invention relates to the test of chips combining both logic network and embedded arrays. It more particularly relates to a circuit which isolates during test the logic part from the memory part of such mixed chips. The separate testing of the memory unit permits extensive utilization of redundancy in case of faulty memory element. This leads to increased yield of manufactured mixed memory/logic chips and as a result leads to decreased Shipped Product Quality Level figure.

### Background of the invention

High density, high reliability and low cost are key to product success on the VLSI market. The actual design of microprocessors, microcontrollers and numerous others products, mix large arrays and logic circuits networks on the same chip. In the following description, such chips are called mixed chips.

The test of chips is a key operation as it is the last step before chips are mounted in a customer system. The test coverage is as extensive as possible through a very large number of test patterns applied to the chips. But in order to reduce time processing and cost, the test efficiency is less than 100%, and a probability remains that a chip that has passed test sequence can fail in customer environment due to untested fault. This proportion of untested faulty chips is typically accounted by the Shipped Product Quality Level (SPQL) figure. Yield and SPQL are then directly related to the test efficiency.

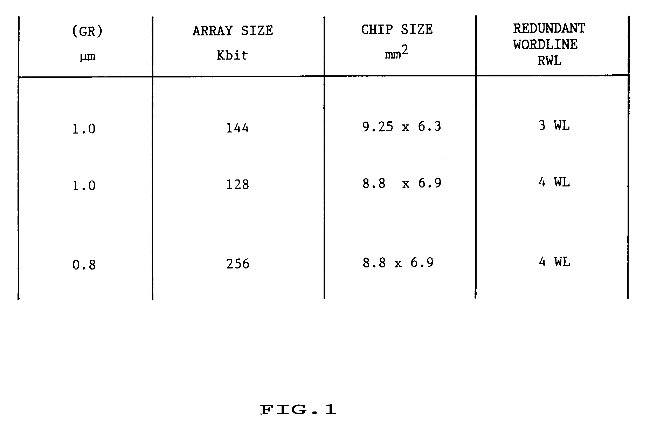

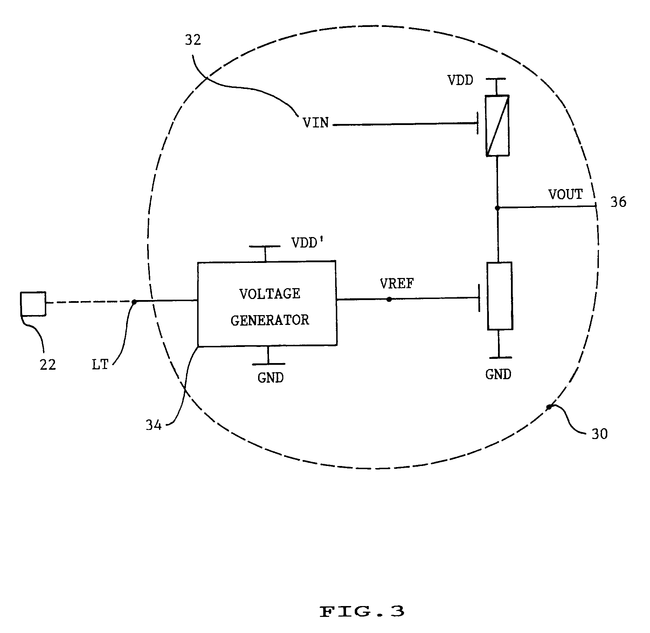

In case of products designed with standalone memory chips and separate logic chips, a test sequence is performed for each chip. A logic test sequence is applied to logic chips and faulty ones are rejected. A separate memory test sequence is applied to standalone memory chips. Faulty memory chips may be repaired if redundant circuits have been designed and if there are not more faults on the array cells than the number of redundant circuits. Redundancy increases the manufacturing yield of memory chips by replacing faulty wordlines or bitlines by redundant ones. A common practice dictates that for arrays of the order of 25% of the total chip area, redundancy is needed. As an example, Fig. 1 illustrates this rule showing the number of the recommended redundant wordlines (RWL) for different array sizes (Kbit) according to Ground rules (GR).

When redundancy is used, a faulty element (i.e a memory cell, a bitline or a wordline) is replaced by the corresponding redundant element. This is generally done by blowing fuses that impair the faulty address and replace it by the redundant one. A typical fault in a logic circuit or in a memory product creates a conductive path between the high and low power supplies. Such short circuit on a chip draws a DC leakage current, named (Idd). This leakage current (Idd) must be lower than an acceptable value. Therefore a specific test sequence is generated in order to measure the real (Idd) value, and compare it to a theoretical one (Idd test). A particularity which becomes a critical feature in case of mixed chips, is that this leakage current value is of the same order for an array than for a logic network (a few mA). When the (Idd) measured for a logic chip is greater then the (Idd test), the chip is rejected because there is no possibility to repair the leaky circuits. In case of a memory chip, the (Idd) current is also compared to an (Idd test) value. But in case of a higher current, other test patterns are performed which test the redundancy. The faulty elements are then replaced by redundant ones. It clearly appears that redundancy offers a significant contribution to improve the manufacturing yield of chips embedding memory products.

Now referring to the mixed chips, the leakage currents may be due either to the logic part of the chip or to the memory part of the chip or to both logic and memory circuits. As it was previously explained, the theoretical value of (Idd test) for logic and memory is equivalent. It means that a single (Idd test) value is taken into account for the comparison with the measured value. Furthermore, a single Idd test sequence is generated for the mixed chip. So the measured leakage current value is not identified, and in case of a higher value than the allowed one, the chip is rejected. Thus the redundancy in arrays is inefficient since most of faulty chips are rejected, even those where the fault is due to a memory element which could have been repaired. For that reason, some mixed designs do not implement the redundancy as there is no way to use it. Thus the manufacturing yield of mixed chips is impacted and is lower than it could be. The overall quality of the product would be improved if the faulty memory elements were identified and repaired by redundancy. Therefore there is a need for mixed chips to implement a satisfactory solution from a SPQL point of view. The problem is then to identify a fault due to a defect in a logic circuit from a fault due to a defect in the memory unit.

One solution is to build a specific test sequence for mixed chips, with the appropriate tools, such as the one described below. A first Idd test sequence is applied to the chip. If the test is good, i.e if the Idd value is less than the expected one, then a memory test sequence is applied and the chip may be sorted according to whether the memory is good, repairable or not repairable. In case of a high Idd value, the chip is not rejected and a memory test sequence is applied. If a faulty element is detected in the memory, redundancy is then tested and the faulty circuit is replaced. But at this step, one can not say that the chip is fully unfaulty because the high Idd may not be due to the faulty memory element. For example, a bitline to bitline short or a wordline to wordline short does not draw any Idd current, but this kind of fault is also detected with the memory test sequence, and then corrected. In case of this kind of fault, the high leakage current value may still remain after the first repair. So if this solution is applied, there is no way to be sure that all faults have been detected before shipping. Thus the SPQL will be degraded. From the economical point of view, because of a degradation in the customer satisfactory, this solution is a prohibitive one. Then, a low cost and reliable solution is preferably based on a test sequence which is able to test the logic part independently from the memory part of the mixed chip. On others words, the mixed chip has to be tested just as if it were made of two separate chips. It means that test patterns are applied to logic circuits first and high Idd chips are rejected. Then the Idd test sequence is applied to the memory part of the only low Idd logic chips. Faulty memory elements can be identified and redundancy is used if necessary.

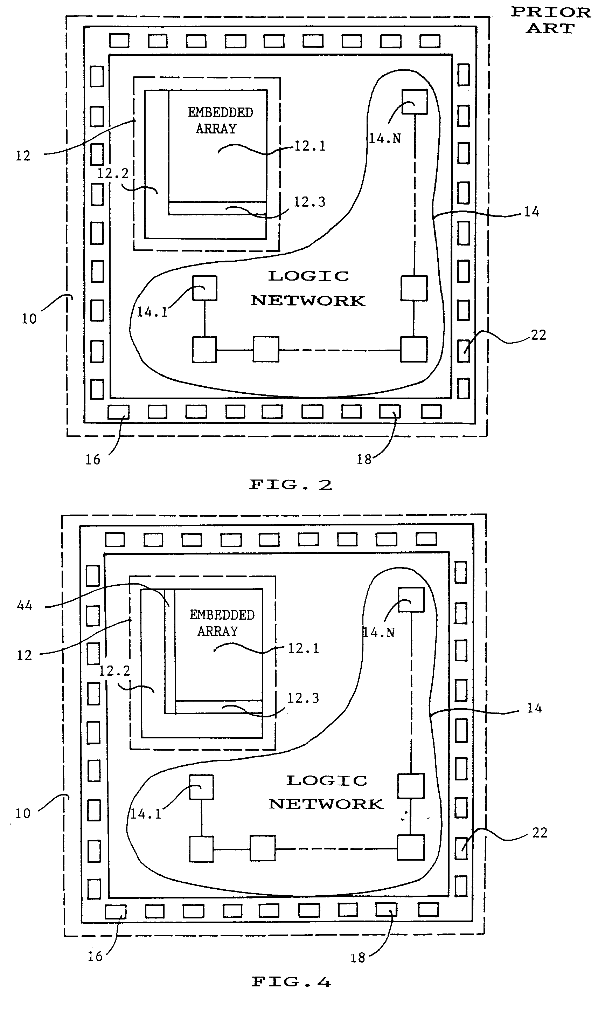

The following will describe a possible implementation of such a test sequence and its disadvantages. This will be explained in reference to Fig. 2 which illustrates a part of a conventional mixed chip (10) with an embedded array (12) and a logic circuits network (14). A standard embedded array (12) is composed of a memory unit (12.1) connected to I/O circuits (12.2) (such as drivers/receivers and sense amplifiers) and eventually redundancy (12.3). The logic circuits network (14) composed of numerous logic circuits (14.1 to 14.N), is distributed all around the embedded array in order to carry on data processing operations. The two primary input terminals (16) and (18) are adapted to supply the VDD power supply and the GND power supply to the whole chip thru two independent metallized grids respectively composed of internal VDD (GND) rails distributed in a regular manner. Moreover, a standard mixed chip (10) has two basic operating modes : the SYSTEM mode for normal operation, and the TEST mode used in manufacturing environment. In the SYSTEM mode, internal reference voltages are commonly used to maintain a constant DC current in some circuits which require a specific operating mode. Such internal reference is generated thru a voltage generator driven by a constant signal (LT). (LT) is delivered through a standard primary input terminal (22) and is set either to a SYSTEM value when the DC current is required, or (LT) is set to a TEST value during the (Idd) test sequence in order to switch off those DC dissipated circuits and therefore to allow a correct measure of the leakage current. For sake of illustration, Fig.3 shows a CMOS logic circuit (30), controlled by (LT). (30) is composed of a PFET receiving the input signal VIN (32), and a NFET connected in series and receiving a reference voltage Vref. The PFET and the NFET transistors are biased between VDD and GND. The reference voltage Vref is generated through a reference voltage generator (34) supplied between GND and a second power supply VDD'. When (34) is ON, i.e in the SYSTEM mode, LT is low and Vref is tied to VDD'. Therefore, the NFET is ON and drives a DC constant current. VOUT (36) is tied to GND when (32) is high. When (32) is low, the PFET switches ON, and (36) is high but at a voltage lower than VDD due to the current in the NFET device.

In the manufacturing environment, i.e in the TEST mode, the (LT) value is inverted. Vref is tied to GND and the NFET device switches off. In that way, the constant DC current value on the chip is null, except if there are faulty circuits which dissipate leakage currents. The Idd test sequence is thus applied and the leakage currents are measured. Good chips are then shipped with the (LT) pad supplied with the (LT) SYSTEM value.

Turning to the description of a possible test sequence for mixed chips, one solution is to have several VDD (GND) power supply grids, one VDD (GND) grid for the logic and an other VDD (GND) grid for the array. As it is previously described, the power supply distribution on VLSI chips is regular, in order to have supplying grids which are technology independent and design independent. Then in case of separate grids for logic and memory, the power supply distribution becomes more and more complex as soon as there are several embedded arrays on the chip. Such a solution is no more suitable for mixed chips designed with several embedded arrays.

Thus it is highly desirable to preserve a common power supply grid both for logic circuits network and embedded arrays, and to implement a new circuit which operates as a separator between the two parts during the TEST mode. It will allow first to test the logic part and to sort chips according to faulty logic part, then to pursue the test only for embedded arrays of good chips. It will therefore allow to use redundancy in case of a faulty memory element. This will improve the manufacturing yield of mixed chips.

### Objects of the invention

It is therefore a primary object of the present invention to provide a test circuit in order to increase the manufacturing yield and improve the SPQL figure of semiconductor product mixed chips.

It is therefore a second object of the present invention to provide a test circuit for mixed chip which is independent of the location and the number of embedded arrays.

It is another object of the present invention to provide a test circuit which allows to power first the logic part and then to power the memory part of mixed chips during the TEST mode.

It is still another object of the present invention to provide a test circuit in order to sort mixed chips according to faulty logic part or to faulty memory part.

It is still another object of the present invention to provide a tested mixed chip with a high reliability-to-cost ratio.

### Summary of the invention

According to the basic principles of the present invention, there is provided a test circuit for mixed chips which includes on a same support at least one embedded array and a logic circuit network.

Such a semiconductor chip has two standard operating modes, the SYSTEM mode for normal operations and the TEST mode used in manufacturing environment.

The present invention provides a test circuit which fully isolates the memory unit of embedded arrays from the logic circuit network in TEST mode and which connects the embedded arrays to the logic circuit network in SYSTEM mode. This allows to apply the logic test sequence to the only logic part of the chips, and reject the faulty ones. Memory part is then tested on the good chips. In case of a faulty memory element, a redundant circuit is used to replace the faulty one. This allows to increase the manufacturing yield of produced mixed chips.

The features believed to be characteristic of this invention are set forth in the claims. The invention itself, however, as well as other objects and advantages thereof, may be best understood by reference to the following detailed description of illustrated preferred embodiment to be read in conjunction with the accompanying drawings in which :

### Brief description of the drawings

- Fig. 1 shows the conventional number of redundant memory elements for several array sizes.
- Fig. 2 shows a state of the art mixed chip with embedded arrays and a logic circuit network.
- Fig. 3 illustrates a state of the art logic circuit driven by the LT signal in the standard CMOS technology.
- Fig. 4 shows the hardware implementation of the present invention in a standard mixed chip.
- Fig. 5 shows one possible hardware implementation of the test circuit of the invention, in case of a VDD power supply separation.

### Description of the preferred embodiment

As noted above, the main object of the invention is to test the memory part of a mixed chip, independently from the logic part. This is implemented through a test circuit which first powers the logic circuits network as well as the I/O circuits of the arrays, and further powers the memory cells of the embedded arrays. This allows to test first the logic part of the chip and then to test the memory part. Furthermore the present solution takes advantage of an existing signal LT currently used for test purposes in standard VLSI chips.

As described in the prior art, redundant circuits are used to repair faulty elements of a memory unit, generally a row or a column of memory cells. The other circuits of the array, i.e the I/O circuits, are not duplicated and then are not repaired. That means the I/O circuits can be tested during the same Idd test sequence as the logic circuits network. Therefore, the test circuit of the invention isolates the memory cells of the embedded arrays from all the others circuits of the chip during the TEST mode. The test circuit operates as a switch which connects or isolates the memory unit from the logic circuits network according to a control value. The test circuit is placed between the power supply rail of the memory cells and the power supply rail of the logic circuits, and is controlled by the LT signal. The power supply rails are isolated when the chip is in the TEST mode and they are connected when the chip is in the SYSTEM mode. During TEST mode, the TEST value of LT is applied to the control gate of the test circuit, turning it off. The power supply rails are then isolated, and only logic circuits network and I/O's circuits are supplied, whereas the memory unit is not supplied. Therefore, the Idd test sequence is applied only to all logic circuits, and a first sort is made upon faulty logic chips. Then the LT signal value is inverted. The test circuit turns on leading to power both logic network and memory unit. The power supply rails are connected just as in the SYSTEM mode. The memory cells can be selected and the Idd test sequence is initialized for the array. A second sort is then performed according to weather the faulty element is repairable or not. Redundancy is then used and production of good chips is thus improved. At this step, the chips that have been rejected are only the chips with faulty logic circuits and the chips with unrepaired memory cells.

Another major point of the invention is the location of the test circuit on the chip. One test circuit is implemented for each row or column of memory cells, instead of a unique test circuit for the whole memory unit. This choice offers better automatization in the design of arrays, as the test circuit is integrated in the design of each row or column of cells. As the design of chips becomes more and more complex and dense, one chip can mix several arrays of different sizes. Then with the invention, the design of the test circuit is unchanged as it is independent of the number of rows or columns of the memory unit.

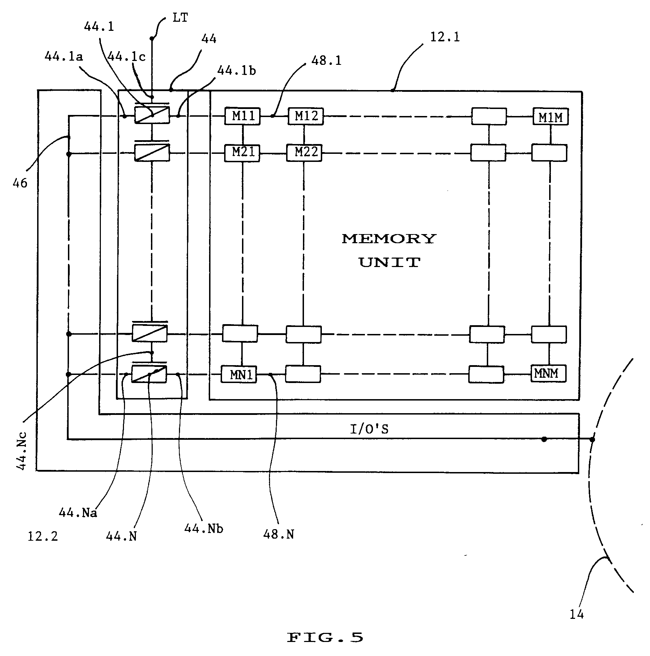

Referring to Fig. 4 and Fig. 5 which respectively show a state of the art mixed chip with the invention and a detailed view of the test circuit, let's describe one possible hardware implementation of the invention, in case of a test circuit placed on the VDD power supply rail. For a (N rows x M columns) memory unit 12.1 of a standard embedded array 12, a test circuit 44 made of N x test elements 44.1 to 44.N, is implemented. One test element 44.1 is made of a PFET device formed by an input gate 44.1a, an output gate 44.1b and a control gate 44.1c. The input gate 44.1a is connected to the VDD power supply rail 46 which supplies the logic circuits network 14 and the I/O circuits 12.2. The output gate 44.1b is connected to the VDD power supply rail 48.1 of the corresponding row of the memory unit 42. The control gate 44.1c receives the LT signal. All input gates 44.1a to 44.Na of the N x PFET devices are cross-connected, and each output gate 44.1b to 44.Nb of the N x PFET devices is respectively connected to each VDD power supply 48.1 to 48.N of each row of the memory unit 42. All the control gates 44.1c to 44.Nc are simultaneously driven by the LT signal.

When the chip operates in TEST mode, LT is high, the control gates 44.1c to 44.Nc are tied to VDD, and the N x PFET devices are switched off. Therefore, there is no connection between the VDD power supply rail of the logic circuits network 46 and the power supply rails 48.1 to 48.N of the memory unit. The memory cells are fully isolated and no selection is possible. The Idd test sequence is then only applied to the logic network 14 plus the I/O circuits 12.2 of the array. Faulty logic chips are rejected. Low Idd logic chips are then supplied in the SYSTEM mode in order to test the embedded arrays.

When LT is supplied with the SYSTEM mode value, the N x PFET devices turn ON, and the VDD power supply rail 46 of logic supplies all the power supply rails of the memory unit, leading to supply the memory cells with VDD. Then the array test sequence is applied. High Idd chips and unrepaired chips are rejected. Good chips are shipped with LT set to the SYSTEM mode value, allowing a full connection between logic circuits network 14 and embedded array 12.

Although the present implementation has been described by reference to a test circuit formed by a PFET device connected to the row of the memory unit thru the VDD power supply rail, and controlled by the LT signal, it is fully applicable to a test circuit formed by a NFET device, connected to the column of the memory unit thru the GND power supply rail and controlled by the inverted LT signal.

The advantages resulting of using the test circuit of the present invention are listed herein below :
- Important cost reduction due to a significant decrease of SPQL.
- Manufacturing yield is improved due to an optimum use of redundancy.
- No logic circuitry needs to be added for the test of the chip.
- Maintain the same design concept of a regular power supply distribution.
- No input needs to be added for driving the invention circuit. All inputs of the chip are fixed in the original design.
- Use the same test tools and test sequences as for separate logic chips and array chips.

## Claims

1. A semiconductor chip biased between a first and a second supply voltage, having two operating SYSTEM and TEST modes and comprising :
• at least one embedded array (12) formed by a (N rows x M columns) memory unit (12.1) connected to standard I/O circuits (12.2),
• a logic circuits network (14) for data processing operations,
• a first chip primary input terminal (16) adapted to supply the first voltage,
• a second chip primary input terminal (18) adapted to supply the second voltage,
• a third chip primary input terminal (22) adapted to generate a control signal LT used in TEST mode for Idd test measurements, and used in SYSTEM mode for supplying an internal reference voltage,
characterized in that it further includes a test circuit (44) responsive to said control signal LT in order to isolate the said memory unit (12.1) from both the said logic circuit network (14) and the said standard I/O's circuits (12.2) in TEST mode, and responsive to said control signal LT in order to connect the said memory unit (12.1) to both the said logic control network (14) and the said standard I/O's circuits (12.2) in SYSTEM mode.

2. The chip of claim 1 wherein the said test circuit (44) consists of N x PFET devices, each one having an input gate, an output gate and a control gate, wherein :
• said first voltage is applied to said input gate (44.1a to 44.Na),
• said output gate (44.1b to 44.Nb) is connected to the corresponding power supply rail (48.1 to 48.N) of each row of the said memory unit (12.1),
• said control signal LT is applied to said control gate (44.1c to 44.Nc),

3. The chip of claim 1 or 2 wherein the said test circuit (44) consists of M x NFET devices, each one having an input gate, an output gate and a control gate wherein :
• said second voltage is applied to said input gate,
• said output gate is connected to the corresponding power supply rail of each column of the said memory unit.
• said control signal LT is applied to said control gate,

4. The chip of claim 1,2 or 3 wherein said embedded array is further provided with redundancy.
